# EUROPEAN PATENT APPLICATION

(11) **EP 4 611 076 A1**
(43) Date of publication of application: **03.09.2025**
(21) Application number: 23900911.1
(22) Date of filing: 03.11.2023
(51) Int. Cl.: H01M 4/62, H01M 4/66, C08K 3/04, C08K 7/24, C08L 65/00, C08G 61/12, H01M 10/0525

(54) **COMPOSITION FOR FORMING ELECTRODE PROTECTION LAYER FOR LITHIUM SECONDARY BATTERY, AND ELECTRODE AND LITHIUM SECONDARY BATTERY INCLUDING SAME**

(30) Priority: 07.12.2022 KR 20220169446
(71) Applicant: LG Energy Solution, Ltd., Seoul 07335 (KR); LG CHEM, LTD., Seoul 07336 (KR)
(72) Inventor: KWON, Soonho, Daejeon 34122 (KR); CHO, Woohyung, Daejeon 34122 (KR); PARK, Sungbin, Daejeon 34122 (KR); KIM, Ki Hwan, Daejeon 34122 (KR); KOH, Jongkwan, Daejeon 34122 (KR); PARK, Eun Kyoung, Daejeon 34122 (KR); CHOI, Hyunju, Daejeon 34122 (KR); YANG, Heemyeong, Daejeon 34122 (KR); SONG, Intaek, Daejeon 34122 (KR); KANG, Joon Koo, Daejeon 34122 (KR)
(74) Representative: Goddar, Heinz J.
(86) International application number: PCT/KR2023/017554
(87) International publication number: WO 2024/122891

(57) **Abstract**

The present disclosure relates to a composition for forming an electrode protective layer for a lithium secondary battery, which not only suppresses heat generation or ignition caused by external impacts, etc., and thus has excellent stability, but also makes it possible to provide electrodes and batteries having excellent conductivity and rate characteristics, and to an electrode for a lithium secondary battery and a lithium secondary battery comprising the same.

## Description

### [TECHNICAL FIELD]

### Cross Citation with Related Application(s)

This application claims the benefit of Korean Patent Application No. 10-2022-0169446 filed on December 7, 2022 with the Korean Intellectual Property Office, the disclosure of which is hereby incorporated by reference in its entirety.

The present disclosure relates to a composition for forming an electrode protective layer for a lithium secondary battery, which not only suppresses heat generation or ignition caused by external impacts, etc., and thus has excellent stability, but also makes it possible to provide electrodes and batteries having excellent conductivity and rate characteristics, and to an electrode for a lithium secondary battery and a lithium secondary battery comprising the same.

### [BACKGROUND]

As demand for medium- and large-sized devices such as electric vehicles and hybrid electric vehicles, and mobile devices such as smartphones and tablet PCs has increased significantly, demand for secondary batteries as an energy source needed to drive such devices is rapidly increasing. In particular, as the data processing speed and the usage time of the mobile devices increase, lithium secondary batteries, which have higher energy density and operating potential, can maintain excellent characteristics over a long period of time, and have a low self-discharge rate, are being actively developed.

However, as the capacity and energy density of lithium secondary batteries have increased significantly, many ignition and explosion accidents caused by overcharging, exposure to high temperatures, external impacts, etc. of various mobile devices or electric vehicles containing the same have been reported. Thus, recently, one of the major research tasks for lithium secondary batteries is to improve safety by suppressing ignition and explosion.

It is known that the direct cause of ignition, explosion, and the like in the lithium secondary batteries is a short circuit caused by direct contact between a positive electrode and a negative electrode inside the secondary battery due to stimuli applied from the outside, such as high temperatures and external impacts. For example, when a lithium secondary battery is overcharged, or exposed to high temperature or external impacts, the internal temperature of the secondary battery may rise rapidly, causing the separator to shrink, or the internal structure of the secondary battery may be destroyed due to external impacts. As a result, the positive electrode and the negative electrode may come into contact, so that a short circuit may occur. When such a short circuit occurs, the movement of lithium ions and electrons may be concentrated through the contact portion between the positive electrode and the negative electrode so that overcurrent can occur, which may cause heat generation, gas generation inside the battery, and volume expansion, and thus may pose a risk of ignition or explosion of the lithium secondary batteries.

Therefore, in order to suppress ignition and explosion during the short circuit and improve the safety of the secondary batteries, it is necessary to increase the resistance between the electrodes and interrupt the current when high temperatures or external impacts are applied. For this purpose, various attempts have been made to add various functional layers or functional materials to electrodes for lithium secondary batteries to increase resistance when high temperatures are applied, thereby improving the safety of secondary batteries.

However, in the case of electrodes to which previously known functional layers are added, there is a disadvantage in that it is difficult to sufficiently enhance the safety of the lithium secondary battery, or the conductivity or rate characteristics of the lithium secondary battery itself are lowered by the addition of this functional layer. In particular, when the thickness of the functional layer is increased in order to improve the safety of the lithium secondary battery, it is difficult for the electrolyte to penetrate through the functional layer, resulting in a problem that the conductivity and rate characteristics of the electrode itself are greatly reduced.

Due to such problems, there is a continuous need for the development of technology that can further improve the safety of lithium secondary batteries while suppressing deterioration in their conductivity, rate characteristics, and the like.

### [DETAILED DESCRIPTION OF THE INVENTION]

### [Technical Problem]

Therefore, it is an object of the present disclosure to provide a composition for forming an electrode protective layer for a lithium secondary battery, which not only suppresses heat generation or ignition caused by external impacts, etc., and thus has excellent stability, but also makes it possible to provide electrodes and batteries having excellent conductivity and rate characteristics.

It is another object of the present disclosure to provide an electrode for a lithium secondary battery and a lithium secondary battery, which includes a safety functional layer formed from the composition and thus exhibits improved safety and also has excellent conductivity and rate characteristics.

### [Technical Solution]

According to one aspect of the present disclosure, there is provided a composition for forming an electrode protective layer for a lithium secondary battery, comprising: a polythiophene-based conductive polymer that exhibits PTC (positive temperature coefficient) characteristics; and porous conductive carbon particles having a plurality of pores with a diameter of 10 to 300 nm formed therein.

According to another aspect of the present disclosure, there is provided an electrode for a lithium secondary battery comprising: a metal current collector; a safety functional layer which is formed so as to cover at least a part of the metal current collector, and is formed from the composition for forming an electrode protective layer; and an active material layer which comprises an electrode active material and a conductive material, and is formed on the metal current collector and the safety functional layer.

According to yet another aspect of the present disclosure, there is provided a lithium secondary battery comprising: a positive electrode, a negative electrode, and a separator interposed between them, wherein the electrode is included as the positive electrode.

Now, a composition for forming an electrode protective layer for a lithium secondary battery, and a lithium secondary battery, etc. comprising the same according to specific embodiments of the present disclosure will be described.

Terms or words used in the present specification and claims should not be construed as limited to ordinary or dictionary terms, and the present disclosure should be construed with meanings and concepts that are consistent with the technical idea of the present disclosure based on the principle that the inventors can appropriately define concepts of the terms to appropriately describe their own invention in the best way.

The terms used herein are provided to describe the embodiments but not to limit the inventive concept. The singular forms include plural forms unless the context clearly indicates otherwise.

It should be understood that the terms "comprise," "include", "have", etc. are used herein to specify the presence of stated features, integers, steps, components or combinations thereof, but do not preclude the presence or addition of one or more other features, integers, steps, components, or combinations thereof.

According to one embodiment of the present disclosure, there is provided a composition for forming an electrode protective layer for a lithium secondary battery, comprising: a polythiophene-based conductive polymer that exhibits PTC (positive temperature coefficient) characteristics; and porous conductive carbon particles having a plurality of pores with a diameter of 10 to 300 nm formed therein.

The composition according to the one embodiment is used, for example, to form an electrode protective layer (safety functional layer) which is distinguished from the active material layer on the surface of the metal current collector in an electrode for a lithium secondary battery, and includes a polythiophene-based conductive polymer exhibiting PTC characteristics and porous conductive carbon particles.

First, as the lithium secondary battery is activated, the polythiophene-based conductive polymer can exhibit conductivity by doping anions derived from the electrolyte of the secondary battery onto the aromatic thiophene ring of the conductive polymer. Therefore, during the normal charge/discharge process of the secondary battery, the conductive polymer exhibits conductivity, which allows the secondary battery to exhibit appropriate charge/discharge characteristics.

However, the conductive polymer can be de-doped from the aromatic thiophene ring by anions derived from the electrolyte at temperatures above a certain level. As a result, the conductive polymer can act as a nonconductor, thereby increasing resistance and exhibiting PTC characteristics that interrupt the flow of current. Due to the action of such polythiophene-based conductive polymers, an electrode for a lithium secondary battery having an electrode protective layer containing them formed therein can contribute to improving the stability of the lithium secondary battery as described below.

When an external stimulus such as overcharging, high temperature, or external impacts is applied to the lithium secondary battery including the electrode, the temperature inside the battery rises rapidly, such a conductive polymer can be converted into a nonconductor due to the above-described de-doping of anions or the like. Therefore, it is possible to significantly increase the resistance within the electrode, to interrupt the flow of current between the metal current collector and the active material layer, to prevent overcurrent due to short circuit between electrodes, and to suppress heat generation, ignition, explosion, gas generation, etc. in secondary batteries.

By the way, when the electrode protective layer is formed thinly, the generation of heat, etc., cannot be sufficiently suppressed, and the safety of the lithium secondary battery may not be sufficient. When the electrode protective layer is formed thickly in order to solve this problem, it becomes difficult for the electrolyte to permeate through the electrode protective layer, which may reduce the doping effect of the conductive polymer. As a result, the conductivity of the electrode including an electrode protective layer and an active material layer may deteriorate, and the overall rate characteristics of the secondary battery may also deteriorate.

However, the porous conductive carbon particles formed with a plurality of pores of 10 to 300 nm included in the composition of one embodiment facilitate penetration of the electrolyte solution due to their own porosity, and can exhibit excellent electronic conductivity and thermal conductivity by thermal diffusion. As a result, in case where an electrode protective layer is formed from the composition of one embodiment including the same, even if the electrode protective layer is formed thickly, it not only exhibits excellent electrolyte permeability, but also enables an electrode containing it to exhibit improved conductivity. Furthermore, due to the excellent thermal conductivity of the porous conductive carbon particles, an electrode including an electrode protective layer formed from the composition of one embodiment can effectively diffuse heat within the electrode, thereby exhibiting further improved safety.

Therefore, the composition of one embodiment and the electrode protective layer formed therefrom can contribute to improving the safety of a lithium secondary battery, and even when formed thickly, the electrode and the lithium secondary battery including the same can exhibit excellent conductivity and rate characteristics.

Meanwhile, the polythiophene-based conductive polymer included in the composition of one embodiment exhibits the above-mentioned PTC characteristics, wherein the effective operating temperature at which such conductive polymers are converted into a nonconductor may be 70 to 130°C, or 80 to 125°C. As the conductive polymer is converted into a nonconductor at this effective operating temperature, the conductive polymer can more effectively suppress ignition or explosion of the secondary battery when external stimulation is applied, without inhibiting the normal charge/discharge process of the secondary battery.

Further, the conductive polymer is a polythiophene-based polymer or copolymer containing substituted or unsubstituted thiophene-based repeating units in an amount of 50 mol% or more, or 70 mol% or more, or 90 to 100 mol% of the total repeating units.

In a more specific example, the conductive polymer may be a polythiophene-based polymer or copolymer in which an alkylene oxide group is bonded to a thiophene ring in the repeating unit, for example, a homopolymer or copolymer containing a repeating unit of the following Chemical Formula 1: 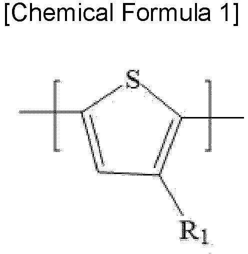
wherein, in Chemical Formula 1, R₁ is a functional group of the following Chemical Formula 2, 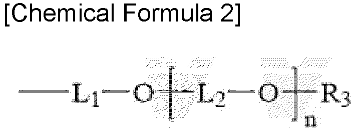
wherein, in Chemical Formula 2, L₁ is a single bond or an alkylene group, L₂ is an alkylene group, R₃ is hydrogen or an alkyl group, and n is an integer in the range of 1 to 5000, or 10 to 2000, or 50 to 1000, wherein the alkylene group may be an alkylene group having 2 to 5 carbon atoms, and the alkyl group may be an alkyl group having 1 to 5 carbon atoms.

Further, such polythiophene-based conductive polymer may have a weight average molecular weight of, for example, 5000 to 100000 g/mol, or 10000 to 80000 g/mol. Thereby, the composition for forming the electrode protective layer can exhibit excellent coating properties and can also exhibit appropriate adhesion to a metal current collector, and the like.

In a more specific example, the polythiophene-based conductive polymer may contain the repeating unit of Chemical Formula 1 in an amount of more than 0 mol%, or 0.001 mol% or more, or 0.01 mol% or more, or 1 mol% or more, and in an amount of 100 mol% or less, or 80 mol% or less, or 50 mol% or less. At this time, the polythiophene-based conductive polymer may include the remaining content of alkyl thiophene-based repeating units excluding the repeating units of Chemical Formula 1, for example, an alkyl thiophene-based repeating unit in which a thiophene ring is substituted with an alkyl group having 1 to 20 carbon atoms or 3 to 15 carbon atoms.

Such a polythiophene-based conductive polymer includes the substituted thiophene ring and thus can exhibit an appropriate effective operating temperature, and the like, and as a result, it can be converted into a nonconductor when a high temperature above a certain level is applied, without impairing the charge/discharge characteristics of the lithium secondary battery, thereby improving the safety of the secondary battery.

Further, due to the above-mentioned predetermined structure, the polythiophene-based conductive polymer can show relatively low affinity, solubility, and the like for organic solvents mainly contained in the slurry composition for forming the active material layer, for example, solvents such as N-methylpyrrolidone, and can also exhibit excellent adhesion to the metal current collector. Therefore, in the process of forming such a polythiophene-based conductive polymer on a metal current collector and then coating and drying the slurry composition to form an active material layer, the phenomenon in which the conductive polymer dissociates and spreads over a wide area of the active material layer can be minimized. Therefore, by using such a polythiophene-based conductive polymer, the electrode protection layer can be uniformly formed near the surface of the metal current collector. Therefore, the conductive polymer can contribute to improving the safety of secondary batteries without impairing their basic performance.

Meanwhile, the conductive polymer may be contained in an amount of 0.001 to 5 parts by weight, or 0.005 to 5 parts by weight, based on 100 parts by weight of the electrode active material (e.g., positive electrode active material) included in the active material layer. Thereby, the electrode of one embodiment may have more excellent safety and charge/discharge characteristics.

The conductive polymer having the repeating unit of the above-mentioned Chemical Formula 1, etc. can be prepared, for example, by subjecting a halogenated thiophene compound and an alkylene glycol compound to a substitution reaction to prepare a monomer to which the functional group of the Chemical Formula 2 is bonded, and then polymerizing such monomers alone or by copolymerizing them with other monomers such as alkylthiophene. Specific conditions for preparing such monomers and polymers are described in the Preparation Example described later.

Meanwhile, the composition of one embodiment includes porous conductive carbon particles having a plurality of pores with a diameter of 10 to 300 nm, or 30 to 250 nm, together with the above-mentioned polythiophene-based conductive polymer. Such porous conductive carbon particles can be obtained, for example, from carbonaceous materials such as hard carbon and/or soft carbon, and are prepared by modifying or surface-treating the carbonaceous material so as to have porosity, or the conductive carbon particles having the above porosity can be commercially obtained and used.

Such porous conductive carbon particles exhibit excellent dispersibility in organic solvents together with the conductive polymer, so that a good electrode protective layer can be formed on a metal current collector with the composition of one embodiment containing the same. Further, the porous conductive carbon particles facilitate penetration of the electrolyte through the electrode protective layer, and can exhibit excellent electrical and thermal conductivity by themselves.

Therefore, even if a thicker electrode protective layer is formed with the composition of one embodiment in order to further improve the safety of the lithium secondary battery, such an electrode protective layer exhibits excellent electrolyte permeability and excellent conductivity, and therefor, can contribute to improving not only the safety of lithium secondary batteries but also their conductivity and rate characteristics.

The porous conductive carbon particles have a number average particle diameter (D50) of 0.5 to 20 *µ*m, or 1 to 15 *µ*m, or 1.5 to 10 *µ*m, from the viewpoint of excellent dispersibility in the solvent and coatability of the composition of one embodiment.

Further, such porous conductive carbon particles may have a porosity of 10 to 40%, or 15 to 35%, and can exhibit porosity defined by a specific surface area of 20 to 600 m²/g, or 30 to 500 m²/g, from the viewpoint of the above-mentioned electrolyte permeability and excellent electrical and thermal conductivity.

The above-mentioned porous conductive carbon particles may be contained in an amount of 0.1 to 80 parts by weight, or 0.5 to 60 parts by weight, based on 100 parts by weight of the polythiophene-based conductive polymer. Depending on the content of such porous conductive carbon particles, a good electrode protective layer can be formed from the composition of one embodiment, and the electrode protection layer can effectively contribute to improving the safety, rate characteristics, conductivity, etc. of the lithium secondary batteries.

Meanwhile, the composition of one embodiment can be prepared in the form of a liquid composition by dissolving or dispersing the above-mentioned conductive polymer and porous conductive carbon particles in an organic solvent such as chloroform, tetrahydrofuran (THF), toluene, or xylene at a concentration of about 0.1 to 5 wt.%. Such a composition can be coated onto a metal current collector and dried to form an electrode protective layer. Subsequently, the slurry composition described later is coated and dried to form an active material layer, which can be then rolled to produce an electrode for a lithium secondary battery.

At this time, the composition of one embodiment may further include at least one additive selected from the group consisting of an additional carbon-based conductive material, a binder, and an esterified saccharide.

At this time, as the carbon-based conductive material and the binder, the same components as those included in the active material layer described later can be used, and addition of these components can further improve the conductivity of the electrode of one embodiment, the adhesiveness or mechanical properties of the safety functional layer, etc. For example, typical examples of the carbon-based conductive material include carbon black or carbon nanotubes.

Moreover, a monosaccharide, oligosaccharide, or polysaccharide having an acyl group can be used as the esterified saccharide. This component generates gas when the secondary battery is overcharged, and can play the role of blocking the conductive path between the metal current collector and the electrode active material, and addition of this component can further improve the safety of the secondary battery.

Meanwhile, according to another embodiment of the present disclosure, there is provided an electrode for a lithium secondary battery comprising an electrode protective layer (safety functional layer) formed from the composition of the above-mentioned one embodiment. The electrodes of such other embodiments may comprise a metal current collector; a safety functional layer which is formed so as to cover at least a part of the metal current collector, and is formed from the composition of the above-mentioned one embodiment; and an active material layer which comprises an electrode active material and a conductive material, and is formed on the metal current collector and the safety functional layer.

The electrode of such other embodiments includes a safety functional layer which is formed from the composition of the above-mentioned embodiment, and includes the conductive polymer and porous conductive carbon particles on the metal current collector, thereby capable of further improving safety, conductivity, and rate characteristics.

The electrode of such other embodiments further includes a metal current collector, and an active material layer formed over a safety layer formed from the composition of one embodiment, wherein such an active material layer may contain an electrode active material, a conductive material, and optionally a binder. At this time, since it is preferable that the electrode of the other embodiment is a positive electrode, such examples will be mainly described.

In the positive electrode for a lithium secondary battery, the metal current collector may generally have a thickness of 3 to 100 *µ*m, and may be formed of any metal or alloy that has excellent conductivity without causing chemical changes in the secondary battery. Examples of such metal current collectors include metal current collectors such as stainless steel, aluminum, copper, nickel, or titanium, or aluminum or stainless steel whose surface is treated with carbon, nickel, titanium, or silver, and the like. Further, the metal current collector can form fine protrusions and depressions on the surface thereof to enhance the adhesion of the safety functional layer, etc., and can be used in various forms such as a film, a sheet, a foil, a net, a porous body, a foaming body, and a non-woven fabric structure.

In addition, the positive electrode active material included in the active material layer is not particularly limited as long as it is a material capable of reversibly intercalating and de-intercalating lithium ions, and examples thereof include a lithium metal composite oxide containing at least one metal element selected from the group consisting of Co, Mn, Ni, W, Cu, Fe, V, Cr, Ti, Zr, Zn, Al, In, Ta, Y, La, Sr, Ga, Sc, Gd, Sm, Ca, Ce, Nb, Mg and Mo.

More specifically, a compound represented by any one of the following formulas can be used as the positive electrode active material. LiₐA_{1-b}R_{b}D₂(wherein, 0.90 ≤ a ≤ 1.8 and 0 ≤ b ≤ 0.5); LiₐE_{1-b}R_{b}O_{2-c}D_{c}(wherein, 0.90 ≤ a ≤ 1.8, 0 ≤ b ≤ 0.5, and 0 ≤ c ≤ 0.05); LiE_{2-b}R_{b}O_{4-c}D_{c}(wherein , 0 ≤ b ≤ 0.5, 0 ≤ c ≤ 0.05); LiₐNi_{1-b-c}CO_{b}R_{c}D_{α}(wherein, 0.90 ≤ a ≤ 1.8, 0 ≤ b ≤ 0.5, 0 ≤ c ≤ 0.05 and 0 < α ≤ 2); LiₐNi_{1-b-c}Co_{b}R_{c}O_{2-α}Z_{α}(wherein, 0.90 ≤ a ≤ 1.8, 0 ≤ b ≤ 0.5, 0 ≤ c ≤ 0.05 and 0 < α < 2); LiₐNi_{1-b-c}Co_{b}R_{c}O_{2-α}Z₂(wherein, 0.90 ≤ a ≤ 1.8, 0 ≤ b ≤ 0.5, 0 ≤ c ≤ 0.05 and 0 < α < 2); LiₐNi_{1-b-c}Mn_{b}R_{c}D_{α}(wherein, 0.90 ≤ a ≤ 1.8, 0 ≤ b ≤ 0.5, 0 ≤ c ≤ 0.05 and 0 < α ≤ 2); LiₐNi_{1-b-c}Mn_{b}R_{c}O_{2-α}Z_{α}(wherein, 0.90 ≤ a ≤ 1.8, 0 ≤ b ≤ 0.5, 0 ≤ c ≤ 0.05 and 0 < α < 2); LiₐNi_{1-b-c}MnₚR_{c}O_{2-α}Z₂(wherein, 0.90 ≤ a ≤ 1.8, 0 ≤ b ≤ 0.5, 0 ≤ c ≤ 0.05 and 0 < α < 2); LiₐNi_{b}E_{c}G_{d}O₂(wherein, 0.90 ≤ a ≤ 1.8, 0 ≤ b ≤ 0.9, 0 ≤ c ≤ 0.5 and 0.001 ≤ d ≤ 0.1); LiₐNi_{b}Co_{c}Mn_{d}GeO₂(wherein, 0.90 ≤ a ≤ 1.8, 0 ≤ b ≤ 0.9, 0 ≤ c ≤ 0.5, 0 ≤ d ≤0.5 and 0.001 ≤ e ≤ 0.1); LiₐNiG_{b}O₂(wherein, 0.90 ≤ a ≤ 1.8 and 0.001 ≤ b ≤ 0.1); LiₐCoG_{b}O₂(wherein, 0.90 ≤ a ≤ 1.8 and 0.001 ≤ b ≤ 0.1); LiₐMnG_{b}O₂(wherein, 0.90 ≤ a ≤ 1.8 and 0.001 ≤ b ≤ 0.1); LiₐMn₂G_{b}O₄(wherein, 0.90 ≤ a ≤ 1.8 and 0.001 ≤ b ≤ 0.1); QO₂; QS₂; LiQS₂; V₂O₅; LiV₂O₅; LiTO₂; LiNiVO₄; and Li_{(3-f)}J₂(PO₄)₃(0 ≤ f ≤ 2).

In the above formulas, A is Ni, Co, Mn or a combination thereof; R is Al, Ni, Co, Mn, Cr, Fe, Mg, V, or a combination thereof; D is O, F, S, P or a combination thereof; E is Co, Mn or a combination thereof; Z is F, S, P or a combination thereof; G is Al, Cr, Mn, Fe, Mg, La, Ce, V or a combination thereof; Q is Ti, Mo, Mn or a combination thereof; T is Cr, V, Fe, Sc, Y or a combination thereof; and J is V, Cr, Mn, Co, Ni, Cu or a combination thereof.

Further, those having a coating layer on the surface of each compound can be used, or a mixture of the above-mentioned compound and a compound having a coating layer can be used. The coating layer may include, as the coating element compound, an oxide of the coating element, a hydroxide of the coating element, an oxyhydroxide of the coating element, an oxycarbonate of the coating element, and a hydroxycarbonate of the coating element. The compounds constituting these coating layers may be amorphous or crystalline compounds. As the coating element included in the coating layer, Mg, Al, Co, K, Na, Ca, Si, Ti, V, Sn, Ge, Ga, B, As, Zr, or a mixture thereof can be used.

Further, the conductive material used in the active material layer is used to impart conductivity to the electrode, and the conductive material can be used without limitation as long as it has electronic conductivity without causing chemical changes in the battery to be configured. Specific examples thereof include natural graphite, artificial graphite, carbon black, carbon fiber, carbon nanotubes, metal powder such as copper, nickel, aluminum and silver, metal fibers, and the like. Further, conductive materials such as polyphenylene derivatives can be used alone or in a mixture of one or more thereof.

The conductive material may be added in an amount of 1 to 50% by weight, or 2 to 20% by weight, based on the total weight of the active material layer. Thereby, it is possible to ensure preferable formation of the positive electrode while imparting excellent electrical characteristics to the positive electrode.

The binder plays a role in making the particles of the positive electrode active material adhere well to each other and further improving the binding properties of the active material layer. As a typical example thereof, the above-mentioned halogenated polyolefin-based polymer binder, polyvinylalcohol, carboxymethylcellulose, hydroxypropylcellulose, diacetylcellulose, polyvinylchloride, carboxylated polyvinylchloride, ethylene oxide-containing polymers, polyvinylpyrrolidone, polyurethane, polyethylene, polypropylene, styrene-butadiene rubbers, acrylated styrene-butadiene rubbers, epoxy resins, nylon, and the like can be used.

The binder may be added in an amount of 1 to 50% by weight, or 2 to 30% by weight, based on the total weight of the active material layer. Thereby, it is possible to form a positive electrode with excellent durability without impairing the electrical characteristics and/or capacity characteristics of the positive electrode.

The above-mentioned active material layer can be formed by dissolving or dispersing each component such as the positive electrode active material, conductive material, and binder in a medium such as an organic solvent to form a slurry composition, and then coating, drying, and rolling the slurry composition on a metal current collector on which the safety functional layer is formed.

At this time, examples of media such as the organic solvent include N-methyl-2-pyrrolidone (NMP), methoxy propyl acetate, butyl acetate, glycol acid, butyl ester, butyl glycol, methylalkylpolysiloxane, alkylbenzene, propylene glycol, xylene, monophenyl glycol, or the like, among which NMP, etc. can be appropriately used considering the dispersibility and processablity of the above-mentioned positive electrode active material and conductive material.

Meanwhile, since the process and conditions for forming the active material layer can follow general positive electrode formation processes and conditions, further description thereof will be omitted.

The active material layer formed by the above-mentioned method may have a thickness of 5 to 200 *µ*m, or 10 to 100 *µ*m, and the safety functional layer may have a uniform thickness of 0.01 to 20 *µ*m, 0.05 to 10 *µ*m, or 0.5 to 5 *µ*m. As the safety protective layer is formed to the above-mentioned uniform thickness near the surface of the metal current collector, the conductive polymer contained in the safety functional layer can suppress direct contact between the active material layer and the metal current collector when applying an external stimulus such as an external impact, thereby ensuring improved safety of the secondary battery. Further, as the safety functional layer includes porous conductive carbon particles, it is possible to ensure excellent conductivity of the electrode and excellent rate characteristics of the secondary battery even if the safety functional layer is formed to be relatively thick.

Meanwhile, according to yet another embodiment of the present disclosure, there is provided a lithium secondary battery comprising: a positive electrode, a negative electrode, and a separator interposed between them, wherein the electrode of the other embodiment is included as the positive electrode.

In such a lithium secondary battery, the negative electrode is produced by coating, drying, and rolling a negative electrode active material on a negative electrode current collector, and may further include a conductive material and a binder as necessary.

The negative electrode active material may include, for example, graphite having a complete layered crystal structure such as natural graphite, soft carbon having a low-crystalline layered crystal structure (graphene structure in which hexagonal honeycomb shaped planes of carbon are arrayed in the form of a layer), hard carbon having a structure in which the low-crystalline structures are mixed with non-crystalline parts, carbon and graphite materials such as artificial graphite, expanded graphite, carbon fiber, hardly graphitizable carbon, carbon black, carbon nanotubes, fullerene, activated carbon; or metal composite oxides such as LiₓFe₂O₃(0≤x≤1), LiₓWO₂(0≤x≤1), SnₓMe₁₋ₓMe'_{y}O_{z} (Me: Mn, Fe, Pb, Ge; Me': Al, B, P, Si, Group 1, 2, 3 elements in the periodic table, halogen; 0<x≤1; 1≤y≤3; 1≤z≤8); lithium metal; lithium alloys; silicon, silicon oxide or silicon-based alloys; tin-based alloys; a conductive polymer such as polyacetylene; Li-Co-Ni based materials; titanium oxide; or lithium titanium oxide, etc.

In one example, the negative electrode active material may include both graphite and silicon (Si)-containing particles, the graphite may include at least one of natural graphite with a layered crystal structure and artificial graphite with an isotropic structure, and the silicon (Si)-containing particles are particles containing as a main component silicon (Si) as a metal component, and may include silicon (Si) particles, silicon oxide particles, or a mixture of the silicon (Si) particles and silicon oxide particles.

In addition, the conductive material and binder that can be used together with the negative electrode active material may be the same components as the conductive material and binder included in the positive electrode active material layer.

Further, the negative electrode active material layer containing the negative electrode active material may have a thickness of 100 *µ*m to 200 *µ*m, or 120 *µ*m to 200 *µ*m.

Further, the negative electrode current collector is not particularly limited as long as it has high conductivity without causing chemical changes in the battery. For example, copper, stainless steel, nickel, titanium, fired carbon, etc. can be used, and in the case of copper or stainless steel, materials surface-treated with carbon, nickel, titanium, silver, etc. may be used.

In addition, similar to the positive electrode current collector, the negative electrode current collector may have fine protrusions and depressions formed on a surface thereof to enhance adherence of a negative electrode active material layer, and may be formed in various forms such as a film, a sheet, a foil, a net, a porous body, a foaming body, and a non-woven fabric structure. Moreover, the average thickness of the negative electrode current collector can be appropriately applied in the range of 3 to 100 *µ*m in consideration of the conductivity and total thickness of the negative electrode to be produced.

Further, the separator is interposed between the positive electrode and the negative electrode, and a thin insulating film having high ion permeability and mechanical strength is used. The separator is not particularly limited as long as it is commonly used in this field. Specifically, chemically resistant and hydrophobic polypropylene; glass fiber; or sheets or non-woven fabrics made of polyethylene, etc. can be used. In some cases, a composite separator can be used in which inorganic particles/organic particles are coated by an organic binder polymer onto a porous polymer substrate such as a sheet or non-woven fabric. When a solid electrolyte such as a polymer is used as the electrolyte, the solid electrolyte can also serve as a separator. In addition, the separator may have an average pore diameter of 0.01 to 10 *µ*m, and an average thickness of 5 to 300 *µ*m.

The above-mentioned lithium secondary battery may further include an electrolyte, wherein such an electrolyte may be an electrolyte containing a nonaqueous organic solvent and a lithium salt, or an electrolyte membrane containing an organic or inorganic solid electrolyte, and these may be mixed and used together. However, the types of electrolytes that can be used are well known to those skilled in the art, and are not particularly limited in batteries of other embodiments, and thus, further description thereof will be omitted.

### [Advantageous Effects]

As described above, even if the internal temperature of the battery rises rapidly due to external stimuli such as overcharging, high temperature, or external impacts, the electrode and lithium secondary battery including the electrode protective layer formed from the composition of the present disclosure can effectively interrupt overcurrent and minimize ignition and explosion due to the relatively thick electrode protective layer (safety functional layer) formed near the metal current collector. Thereby, the lithium secondary battery can exhibit excellent safety.

Furthermore, the lithium secondary battery can exhibit excellent conductivity and rate characteristics despite the relatively thick electrode protection layer.

### [DETAILED DESCRIPTION OF THE EMBODIMENTS]

Hereinafter, various embodiments of the present disclosure will be described in detail so that those skilled in the art can easily carry out them. However, the present disclosure may be modified in various different ways, and is not limited to the embodiments set forth herein.

### Preparation example: Synthesis of monomer and conductive polymer

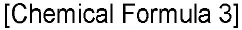

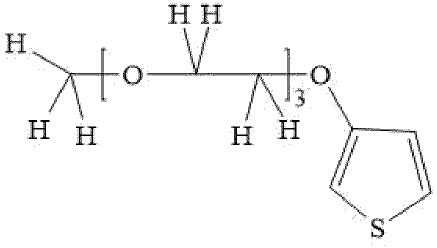

After creating the inside of the 3-way RBF (Round Bottom Flask) into a nitrogen environment through nitrogen flowing, 2.34 g (0.01 mol) of copper(I) iodide and 50.36 g (0.31 mol) of triethylene glycol were added. 3.68 g (0.096 mol) of sodium hydride 60% in mineral oil was slowly added to the RBF, and the mixture was stirred while maintaining a nitrogen environment. After stirring for about 1 hour, 10.0 g (0.06 mol) of 3-bromothiophene was added, and the mixture was refluxed at about 100°C for about 24 hours. The reaction solution was filtered through a pressure reducing device, and then washed with 100 mL of dichloromethane solution, and then washed with NH₄Cl and brine in that order. The solvent was removed through reduced pressure distillation, and the crude product was purified by column chromatography (hexane:ethyl acetate=60:40) to obtain about 9.0 g (yield: 60%) of the target compound (monomer compound of Chemical Formula 3).

124 g (767 mmol) of iron(III) chloride was dissolved in 1000 ml of methylene chloride, and 3.0 g (12.2 mmol) of the monomer compound of Chemical Formula 3 and 47.8 g (243 mmol) of 3-octyl thiophene were added to the solution, and the mixture was subjected to a polymerization reaction with stirring at about 25°C for 24 hours. The reaction solution was placed in an osmosis membrane with a molecular weight of cut-off (MWCO) of 5000, and then immersed in 1500 ml of acetonitrile solvent to remove unreacted iron(III) chloride, monomers, and the like. The residue precipitated inside the osmosis membrane was washed with methanol, and dried at about 25°C to obtain the desired conductive polymer. The weight average molecular weight (Mw) of the conductive polymer was confirmed to be about 34,000 g/mol.

### Example 1: Production of positive electrode and lithium secondary battery

### (Production of positive electrode)

20g of the conductive polymer (Mw=34,000g/mol) obtained in Preparation Example and
6g (30 parts by weight based on 100 parts by weight of the conductive polymer) of the porous conductive carbon particles (pore diameter: 10-300nm, D50: 1-3 *µ*m) were dissolved in 1,980g of chloroform solvent to obtain a composition. This composition was gravure- coated and dried on an aluminum (Al) thin film, which is a positive electrode current collector, to thereby form a safety functional layer with a thickness of about 5 *µ*m.

LiCoO₂, a conductive material (carbon black), and a binder (polyvinylidene fluoride) were added as positive electrode active materials to N-methyl-2-pyrrolidone (NMP) at a weight ratio of 97.5:1:1.5 to prepare a positive electrode slurry (solids content: 60 wt.%). The positive electrode slurry was coated onto the conductive polymer-containing layer (however, the weight of the conductive polymer in the safety functional layer was about 0.5 parts by weight based on a total of 100 parts by weight of the positive electrode active material, the conductive material and the binder), dried and then roll-pressed to form an active material layer with a total thickness of 58 *µ*m, thereby producing a positive electrode.

### (Production of negative electrode)

A negative electrode active material (graphite), a binder (SBR-CMC), and a conductive material (carbon black) were added to water as a solvent at a weight ratio of 95:3.5:1.5 to prepare a negative electrode slurry (solids content: 60 wt.%). The negative electrode slurry was coated onto a copper (Cu) thin film as a negative electrode current collector having a thickness of 8 *µ*m, dried and then roll-pressed to produce a negative electrode.

### (Production of separator)

About 8.5 wt.% of polyvinylidene fluoride-hexafluoropropylene copolymer (PVdF-HFP) binder was added to acetone, and then dissolved at a temperature of 50°C for about 12 hours or more to prepare a binder solution. Al₂O₃ powder was added to this binder solution so that Al₂O₃/PVdF-HFP = 90/10 (wt.% ratio), and a slurry was prepared using a ball mill method for 12 hours or more. The slurry prepared in this way was coated onto a polyolefin-based separator with a thickness of about 8 *µ*m using a dip coating method. The coating thickness was adjusted to about 4.5 *µ*m to produce a porous separator.

### (Production of lithium secondary battery)

A positive electrode, a separator, and a negative electrode were sequentially stacked and then pressed using heat and pressure of 90°C and 200kPa to produce an electrode assembly composed of bicells. The assembled electrode assembly was housed in a pouch-type battery case, and ethylene carbonate(EC) and ethylmethyl carbonate (EMC) were mixed at a volume ratio of 30:70, and then an electrolyte in which LiPF₆ was dissolved to 1.0M was injected, thereby producing a lithium secondary battery.

### Example 2: Production of positive electrode and lithium secondary battery

20g of the conductive polymer (Mw=34,000g/mol) obtained in Preparation Example and
6g of the porous conductive carbon particles (pore diameter: 10-300nm, D50: 1~3 *µ*m) (30 parts by weight based on 100 parts by weight of the conductive polymer) were dissolved in 1,980g of chloroform solvent to obtain a composition. This composition is gravure-coated onto an aluminum (Al) thin film, which is a positive electrode current collector, and dried to form a safety functional layer with a thickness of about 10 *µ*m.

After forming the safety functional layer, the same process as in Example 1 was performed to produce a positive electrode and a lithium secondary battery of Example 2.

### Comparative Example 1

A positive electrode and a lithium secondary battery of Comparative Example 1 were produced in the same manner as in Example 1, except that the porous conductive carbon particles were not used.

### Comparative Example 2

A positive electrode and a lithium secondary battery of Comparative Example 2 were produced in the same manner as in Example 1, except that 6g of the carbon black conductive material (30 parts by weight based on 100 parts by weight of the conductive polymer) was used instead of the porous conductive carbon particles.

### Comparative Example 3

A positive electrode and a lithium secondary battery of Comparative Example 3 were produced in the same manner as in Example 1, except that a safety functional layer was not formed on the aluminum (Al) thin film that is the positive electrode current collector.

### Test Example

### 1. Evaluation of high-rate discharge characteristics

The lithium secondary batteries produced in Examples and Comparative Examples were charged under the conditions of constant current (0.7C) and constant voltage (4.47V, 0.025C cut-off), then rested for 10 minutes, and discharged until the voltage reached 3V under the conditions of constant current (0.1C, 0.2C, 0.5C, 1.0C, 1.5C). That is, when the number of charge/discharge cycles increased, the discharge rate was periodically changed to 0.1C, 0.2C, 0.5C, 1.0C, and 1.5C, respectively. Thereby, the high-rate discharge characteristics (rate capability) of each battery were evaluated. These high-rate discharge characteristics were evaluated at a temperature of 45°C.

At this time, the high-rate discharge characteristics of 1.5C are shown in Table 1 below.

### 2. Impact test

10 Lithium secondary batteries produced in Examples and Comparative Examples were prepared for each test, and placed on a flat plate. After placing an iron rod with a diameter of 15.8mm, a 9.1kg weight was freely dropped onto the lithium secondary battery at a height of 61cm above the iron rod.

After free falling, it was measured whether or not any of the 10 batteries could ignite, and the number of batteries that did not ignite is shown as the test results in Table 1 below.

**[Table 1]**

| | Safety functional layer thickness (*µ*m) | High-rate discharge characteristics (%) | Impact test (Number of non-ignition /Total number) |
|---|---|---|---|
| Example 1 | 5 | 87.1 | 9/10 |
| Example 2 | 10 | 85.4 | 10/10 |
| Comparative Example 1 | 5 | 34.7 | 9/10 |
| Comparative Example 2 | 5 | 79.2 | 9/10 |
| Comparative Example 3 | - | 91.1 | 2/10 |

Referring to Table 1, it was confirmed that Examples 1 and 2 are superior to Comparative Example 3 due to the formation of a safety functional layer, and exhibit safety at a level equivalent to or higher than that of Comparative Examples 1 and 2. In particular, it was confirmed that Example 2 shows superior safety compared to Comparative Examples 1 and 2.

In addition, it was confirmed that Examples 1 and 2 include porous conductive carbon particles in the safety functional layer, and thus are equivalent to Comparative Example 3 in which no safety functional layer was formed, and exhibit more excellent rate characteristics (high-rate discharge characteristics) than Comparative Examples 1 and 2.

## Claims

1. A composition for forming an electrode protective layer for a lithium secondary battery, comprising:
a polythiophene-based conductive polymer that exhibits PTC (positive temperature coefficient) characteristics; and
porous conductive carbon particles having a plurality of pores with a diameter of 10 to 300 nm formed therein.

2. The composition for forming an electrode protective layer for a lithium secondary battery according to claim 1, wherein the effective operating temperature of the polythiophene-based conductive polymer is 70 to 130°C.

3. The composition for forming an electrode protective layer for a lithium secondary battery according to claim 1, wherein the polythiophene-based conductive polymer comprises a homopolymer or copolymer containing a repeating unit of the following Chemical Formula 1: 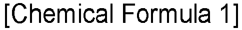 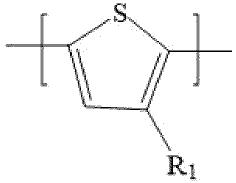
wherein, in Chemical Formula 1, R₁ is a functional group of the following Chemical Formula 2, 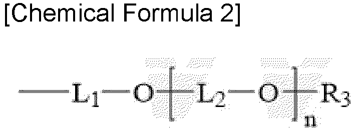
wherein, in Chemical Formula 2, L₁ is a single bond or an alkylene group, L₂ is an alkylene group, R₃ is hydrogen or an alkyl group, and n is an integer in the range of 1 to 5000.

4. The composition for forming an electrode protective layer for a lithium secondary battery according to claim 1, wherein the polythiophene-based conductive polymer has a weight average molecular weight of 5000 to 100000 g/mol.

5. The composition for forming an electrode protective layer for a lithium secondary battery according to claim 1, wherein the porous conductive carbon particles have a number average particle diameter (D50) of 0.5 to 20 *µ*m.

6. The composition for forming an electrode protective layer for a lithium secondary battery according to claim 1, wherein the porous conductive carbon particles have a porosity of 10 to 40% and a specific surface area of 20 to 600 m²/g.

7. The composition for forming an electrode protective layer for a lithium secondary battery according to claim 1, wherein the porous conductive carbon particles are contained in an amount of 0.1 to 80 parts by weight based on 100 parts by weight of the polythiophene-based conductive polymer.

8. The composition for forming an electrode protective layer for a lithium secondary battery according to claim 1, further comprising a carbon-based conductive material of carbon black or carbon nanotubes.

9. The composition for forming an electrode protective layer for a lithium secondary battery according to claim 1, further comprising at least one of a binder or an esterified saccharide.

10. An electrode for a lithium secondary battery comprising:
a metal current collector;
a safety functional layer which is formed so as to cover at least a part of the metal current collector, and is formed from the composition of any one of claims 1 to 9; and
an active material layer which comprises an electrode active material and a conductive material, and is formed on the metal current collector and the safety functional layer.

11. An electrode for a lithium secondary battery according to claim 10, wherein the active material layer has a thickness of 5 to 200 *µ*m, and
the safety functional layer has a thickness of 0.01 to 20 *µ*m.

12. An electrode for a lithium secondary battery according to claim 10, which is formed as a positive electrode.

13. A lithium secondary battery comprising: a positive electrode, a negative electrode, and a separator interposed between them, wherein the electrode of claim 10 is included as the positive electrode.
